# EUROPEAN PATENT APPLICATION

(11) **EP 4 693 374 A1**
(43) Date of publication of application: **11.02.2026**
(21) Application number: 24780030.3
(22) Date of filing: 22.03.2024
(51) Int. Cl.: H01L 21/304, B24B 37/00, C09K 3/14

(54) **METHOD FOR PRODUCING POLISHING COMPOSITION**

(30) Priority: 29.03.2023 JP 2023054103
(71) Applicant: Fujimi Incorporated, Kiyosu-shi, Aichi 452-8502 (JP)
(72) Inventor: KAWANO, Tomoaki, Kiyosu-shi, Aichi 452-8502 (JP); TSUCHIYA, Kohsuke, Kiyosu-shi, Aichi 452-8502 (JP)
(74) Representative: Grünecker Patent- und Rechtsanwälte PartG mbB
(86) International application number: PCT/JP2024/011415
(87) International publication number: WO 2024/203912

(57) **Abstract**

Provided is a method of producing a polishing composition, the method allowing easy checking of a level of dissolution of a chelating agent during a production process. Provided is a method of producing a polishing composition for polishing a surface formed of a silicon material. The method of producing a polishing composition includes preparing a basic chelating agent-containing liquid containing a basic compound, water, and a chelating agent; and mixing a silica dispersion containing silica particles and water, and the chelating agent-containing liquid.

## Description

### [Technical Field]

The present invention relates to a method of producing a polishing composition.

The application claims the priority based on Japanese Patent Application No. 2023-054103, filed on March 29, 2023, the content of which is herein incorporated by reference in its entirety.

### [Background Art]

Conventionally, a surface of a material such as metal, semimetal, non-metal, or an oxide thereof has been finely polished with a polishing composition. For example, a surface of a silicon wafer used as a component of a semiconductor product or the like is generally finished into a high-grade mirror plane via a lapping step, a polishing step, and the like. The polishing step includes, e.g., a stock polishing step and a final polishing step (last polishing step). The stock polishing step includes, e.g., a rough polishing step (primary polishing step) and an intermediate polishing step (secondary polishing step). Patent Document 1 is an exemplary technical reference of a polishing composition used in these polishing steps.

### [Citation List]

### [Patent Literature]

[Patent Document 1] Japanese Patent No. 6882727

### [Summary of Invention]

### [Technical Problem]

A polishing composition used for polishing a surface formed of a silicon material (e.g., a surface of a silicon wafer) may contain a chelating agent. A function of the chelating agent to bind a metal element to form a stable complex ion can lead to exertion of an effect of preventing the silicon material from contamination of metallic impurities in polishing with use of the polishing composition. For example, the example in Patent Document 1 describes use of ethylenediaminetetraacetic acid tetrasodium salt as a chelating agent (paragraph [0042]).

The present inventors focused on the finding that in a polishing composition containing a chelating agent, insufficient dissolution of the chelating agent can result in an undissolved chelating agent remaining together with a metallic element on a polished surface, causing metallic contamination of the surface. However, a polishing composition containing an abrasive (e.g., silica particles) is turbid with the abrasive, making it difficult to check whether the chelating agent is sufficiently dissolved.

The present invention therefore has an object to provide a method of producing a polishing composition containing silica particles and a chelating agent, the method allowing easy checking of a level of dissolution of the chelating agent during a production process.

### [Solution to Problem]

The specification provides a method of producing a polishing composition for polishing a surface formed of a silicon material. The production method includes preparing a basic chelating agent-containing liquid containing a basic compound, water, and a chelating agent; and mixing a silica dispersion containing silica particles and water, and the chelating agent-containing liquid. According to the method, basicity of the chelating agent-containing liquid facilitates good dissolution of a chelating agent in the chelating agent-containing liquid. Moreover, since the chelating agent-containing liquid has no turbidity caused by silica particles before mixing with a silica dispersion, observation (e.g., visual observation) of the chelating agent-containing liquid provides easy checking whether a chelating agent is sufficiently dissolved.

In some embodiments of the method disclosed herein, the silica dispersion, which is to be mixed with the chelating agent-containing liquid, preferably has a pH (indicating a pH just before mixing with the chelating agent-containing liquid and hereinafter sometimes represented as "pH_{Si}") of 6 or more and 14 or less. In other words, the mixing of the silica dispersion and the chelating agent-containing liquid is preferably performed by mixing a basic (i.e., above pH 7.0) chelating agent-containing liquid and a silica dispersion with a pH of 6 or more and 14 or less. Setting the pH of a silica dispersion to be mixed with the chelating agent-containing liquid within these ranges facilitates providing a mixture containing a chelating agent well dissolved.

In some embodiments, as the chelating agent, a compound can be preferably used that is an n-valent acid (n≥2) and has a pKaₙ₋₁ of more than 7.0 as the acid dissociation constant pKa of the chelating agent is defined as pKa₁ to pKaₙ in order of increasing numerical values. In a basic chelating agent-containing liquid, a chelating agent with a pKaₙ₋₁ of more than 7.0 has a greater number of undissociated acid groups (e.g., carboxyl groups) in a chelating agent than a chelating agent with a pKaₙ₋₁ of 7.0 or less, and thus tends to have lower solubility of a chelating agent. Hence, in use of a chelating agent with a pKaₙ₋₁ of more than 7.0, it is more effective to apply the production method disclosed herein.

In some embodiments, the chelating agent preferably contains a pentavalent or more chelating agent. A pentavalent or more chelating agent generally has an excellent capability of trapping metal ions, but also tends to easily cause metallic contamination due to insufficient dissolution. Accordingly, it is particularly significant to apply the production method disclosed herein.

In some embodiments, the polishing composition is a polishing composition for stock polishing of a surface formed of the silicon material. The method disclosed herein can be preferably implemented in an embodiment of producing a polishing composition for stock polishing of a surface formed of a silicon material.

The specification also provides a polishing composition produced by any of the production methods disclosed herein.

### [Description of Embodiments]

Preferred embodiments of the present invention will be described below. Incidentally, matters that are other than those particularly mentioned in the present specification but are necessary for implementation of the present invention can be recognized by those skilled in the art as design matters based on the conventional art in the relevant field. The present invention can be implemented based on contents disclosed in the present specification and common general technical knowledge in the field.

### <Abrasive>

The specification provides a method of producing a polishing composition containing silica particles, a basic compound, a chelating agent, and water. In a typical embodiment of the method disclosed herein, a polishing composition containing the silica particles as an abrasive is produced. The method disclosed herein can be preferably implemented in an embodiment in which an abrasive in the polishing composition is substantially formed of silica particles. The term "substantially" as used herein refers to a state in which 95% by weight or more (preferably 98% by weight or more, more preferably 99% by weight or more, possibly 100% by weight) of particles forming an abrasive are silica particles.

The type of the silica particles is not particularly limited, and can be appropriately selected. The silica particles may be used singly or in combination of two or more kinds thereof. Examples of the silica particles include colloidal silica, fumed silica and precipitated silica. Colloidal silica is particularly preferred because of less capability of generating a scratch on a surface of an object to be polished and potential of exerting good polishing performance (performance to reduce surface roughness and the like). The type of the colloidal silica is not particularly limited, and can be appropriately selected. The colloidal silica can be used singly or in combination of two or more kinds thereof. Examples of colloidal silica to be potentially preferably employed include colloidal silica prepared from water glass (sodium silicate) as a raw material by ion-exchanging (hereinafter also referred to as sodium silicate-derived silica), and colloidal silica produced by sol-gel method (hereinafter also referred to as sol-gel-derived silica). The sol-gel silica is colloidal silica produced by a hydrolysis-condensation reaction of alkoxysilane and is sometimes also referred to as alkoxide-derived colloidal silica.

The absolute specific gravity of silica that forms the silica particles is preferably 1.5 or more, more preferably 1.6 or more, and even more preferably 1.7 or more. The upper limit of the absolute specific gravity of silica is not particularly limited, and is typically 2.3 or less, and e.g., 2.2 or less. As the absolute specific gravity of silica, a measured value derived by liquid replacement using ethanol as a replacing liquid can be employed.

A polishing composition produced by the method disclosed herein may contain particles other than silica particles (hereinafter also referred to as "non-silica particles"), in addition to the silica particles, as abrasives. The non-silica particles may be non-silica inorganic particles, organic particles, or organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonate salts such as calcium carbonate and barium carbonate. Specific examples of the organic particles include polymethylmethacrylate (PMMA) particles, poly(meth)acrylic acid particles, and polyacrylonitrile particles. The (meth)acrylic acid in this context is intended to refer inclusively to acrylic acid and methacrylic acid. The non-silica particles can be used singly or in combination of two or more kinds thereof.

An abrasive in the art disclosed herein may take a form of primary particles or a form of secondary particles formed by aggregation of a plurality of primary particles. The abrasive may contain a mixture of a form of primary particles and a form of secondary particles. In some preferred embodiments, at least a part of the abrasive takes a form of secondary particles.

The average primary particle diameter of the abrasive (e.g., silica particles) is not particularly limited, and in view of improving a polishing removal rate and the like, it is preferably 5 nm or more, more preferably 10 nm or more, particularly preferably 20 nm or more. In view of providing a higher effect of polishing, the average primary particle diameter is preferably 25 nm or more, more preferably 30 nm or more. The abrasive may have an average primary particle diameter of 40 nm or more for use. In some embodiments, the average primary particle diameter may be, e.g., more than 40 nm, more than 45 nm, or more than 50 nm. In view of preventing a scratch and the like, the average primary particle diameter of the abrasive is preferably 200 nm or less, more preferably 150 nm or less, even more preferably 120 nm or less, particularly preferably 100 nm or less. In some embodiments, the average primary particle diameter may be 75 nm or less or 60 nm or less.

The average primary particle diameter of the abrasive, as used herein, refers to a particle diameter calculated from a specific surface area measured by a BET method (BET value) by the formula: average primary particle diameter (nm) = 6000/(true density (g/cm³) × BET value (m²/g)). Measurement of the specific surface area can be performed using e.g., a surface area measurement device with the product name of "Flow Sorb II 2300", manufactured by Micromeritics Instrument Corporation.

The average secondary particle diameter of the abrasive is not particularly limited, and can be appropriately selected from, e.g., the range of about 15 nm to 300 nm. In view of improving a polishing removal rate, the average secondary particle diameter is suitably 20 nm or more, and may be 25 nm or more, preferably 30 nm or more, more preferably 35 nm or more. In some embodiments, the average secondary particle diameter may be, e.g., 40 nm or more, 45 nm or more, preferably 50 nm or more, even more preferably 60 nm or more, or 65 nm or more (e.g., 70 nm or more). In view of preventing generation of a scratch and the like, the average secondary particle diameter, usually may be 250 nm or less, preferably 200 nm or less, more preferably 150 nm or less. In some embodiments, the average secondary particle diameter may be 120 nm or less or 110 nm or less.

The average secondary particle diameter of the abrasive, as used herein, refers to a particle diameter at a point where a cumulative volume accumulated from the point of the minimal particle diameter is 50% in a particle size distribution measured by dynamic light scattering. For example, the measurement can be carried out using a device named model "FPAR-1000" manufactured by Otsuka Electronics Co., Ltd. or an equivalent product thereof

The shape (outer shape) of the abrasive may be globular or non-globular. Specific examples of the particles having non-globular forms include peanut-shaped (i.e., peanut shell-shaped) particles, cocoon-shaped particles, conpeito-shaped particles, and rugby ball-shaped particles.

The average aspect ratio of the abrasive is not particularly limited. The average aspect ratio of the abrasive is theoretically 1.0 or more, can be 1.05 or more or 1.10 or more, and may be 1.15 or more. Increase in the average aspect ratio lead to a tendency of improvement in a polishing removal rate. In some embodiments, the average aspect ratio of the abrasive is greater than 1.2 (particularly, above 1.20), and may be, e.g., 1.22 or more. An abrasive having an average aspect ratio of more than 1.2 is a typical example of the non-globular abrasive. Meanwhile, in view of reducing scratches, improving stability of polishing, and the like, the average aspect ratio of the abrasive is preferably 3.0 or less, more preferably 2.0 or less. In some embodiments, the average aspect ratio of the abrasive may be, e.g., 1.5 or less, 1.4 or less, or 1.3or less.

The shape (outer shape) and the average aspect ratio of the abrasive can be acquired by, e.g., electron microscopy. An exemplary specific procedure for acquiring the average aspect ratio can be as follows: with use of a scanning electron microscope (SEM), collecting a predetermined number (e.g., 200) of abrasive particles each independently having a discriminable shape; drawing a minimum rectangle circumscribed to an image of each of the collected particles; then calculating, as a major axis/minor axis ratio (aspect ratio), a value by dividing the long side length (major axis value) by the short side length (minor axis value) for the rectangle drawn for the image of each of the particles; and deriving the average aspect ratio from an arithmetic average of the aspect ratios for the predetermined number of the particles.

The content of the abrasive is not particularly limited, and can be appropriately set corresponding to a purpose. The content of the abrasive relative to the total weight of a polishing composition may be, e.g., 0.01% by weight or more, 0.05% by weight or more, or 0.1% by weight or more. Increase in the content of the abrasive leads to a tendency of improvement in a polishing removal rate. In some embodiments, the content of the abrasive may be 0.2% by weight or more, 0.5% by weight or more, or 0.6% by weight or more. In view of preventing formation of a scratch and saving usage of the abrasive, the content of the abrasive in some embodiments may be, e.g., 10% by weight or less, 5% by weight or less, 3% by weight or less, 2% by weight or less, 1.5% by weight or less, 1.2% by weight or less, or 1.0% by weight or less. These contents can be preferably applied to, e.g., a content in a polishing slurry (working slurry) to be supplied to an object to be polished.

In the case of a polishing composition to be diluted and used for polishing (i.e., a concentrate), the content of the abrasive is usually, suitably 50% by weight or less, more preferably 40% by weight or less, in view of storage stability, filterability, and the like. Meanwhile, in view of leveraging advantage of a concentrate, the content of the abrasive is preferably 1% by weight or more, more preferably 5% by weight or more.

### <Basic Compound>

A polishing composition produced by the method disclosed herein contains a basic compound. A basic compound, as used herein, refers to a compound that is contained in the polishing composition and thereby has a function to raise the pH of the composition. The basic compound can serve a function to chemically polish a face to be polished, and contribute to improvement in a polishing removal rate. The basic compound may be an organic basic compound or may be an inorganic basic compound. The basic compound can be used singly or in combination of two or more kinds thereof.

Examples of the organic basic compound include quaternary ammonium salts such as tetraalkylammonium salts. Anions in such ammonium salts can be, e.g., OH⁻, F⁻, Cl⁻, Br⁻, I⁻, ClO₄⁻, BH₄⁻, and HCO₃⁻. For example, quaternary ammonium salts such as choline, tetramethylammonium hydroxide, tetraethylammonium hydroxide, tetrapropylammonium hydroxide, tetrabutylammonium hydroxide, and tetramethylammonium bicarbonate can be preferably used. Of these, tetramethylammonium hydroxide (TMAH) is preferable.

Other examples of the organic basic compound include quaternary phosphonium salts such as tetraalkylphosphonium salts. Anions in such phosphonium salts can be, e.g., OH⁻, F⁻, Cl⁻, Br⁻, I⁻, ClO₄⁻, BH₄⁻, and HCO₃⁻. For example, halides and hydroxides of tetramethylphosphonium, tetraethylphosphonium, tetrapropylphosphonium and tetrabutylphosphonium can be preferably used.

Other examples of the organic basic compound include amines such as methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine and triethylenetetramine; piperazine compounds such as 1-(2-aminoethyl)piperazine and N-methylpiperazine; azole compounds such as imidazole and triazole; and guanidine.

Examples of the inorganic basic compounds include ammonia; hydroxides of ammonia, alkali metals or alkaline earth metals; carbonates of ammonia, alkali metals or alkaline earth metals; and bicarbonates of ammonia, alkali metals or alkaline earth metals. Specific examples of such hydroxides include lithium hydroxide, potassium hydroxide (KOH), and sodium hydroxide. Specific examples of such carbonates and bicarbonates include ammonium bicarbonate, ammonium carbonate, lithium bicarbonate, lithium carbonate, potassium bicarbonate, potassium carbonate (K₂CO₃), sodium bicarbonate, and sodium carbonate.

Preferred basic compounds include ammonia, lithium hydroxide, potassium hydroxide, sodium hydroxide, tetramethylammonium hydroxide, tetraethylammonium hydroxide, ammonium bicarbonate, ammonium carbonate, lithium bicarbonate, lithium carbonate, potassium bicarbonate, potassium carbonate, sodium bicarbonate and sodium carbonate. In particular, preferred examples include ammonia, lithium hydroxide, potassium hydroxide, sodium hydroxide, tetramethylammonium hydroxide, lithium carbonate, and potassium carbonate. In terms of a polishing composition used for stock polishing of a surface formed of a silicon material, examples of preferred basic compounds include quaternary ammonium (quaternary ammonium salt). Use of quaternary ammonium can be advantageous, e.g., in view of performance of cancelling a bump around a hard laser mark (HLM) (bump cancellation property), in a polishing composition used for stock polishing of a silicon wafer provided with HLM. Quaternary ammonium may be used singly or in combination of two or more kinds thereof. Particularly, tetramethylammonium hydroxide can be preferably used.

Without particular limitation, in view of good balance between maintenance of a polishing removal rate and a bump cancellation property, quaternary ammonium (e.g., tetramethylammonium hydroxide) and carbonate (e.g., potassium carbonate) are preferably used in combination as basic compounds. In some embodiments, hydroxide of alkali metal or alkaline earth metal (e.g., potassium hydroxide) can be used in addition to quaternary ammonium (e.g., tetramethylammonium hydroxide) and/or carbonate (e.g., potassium carbonate). In an embodiment in which two or more kinds selected from the quaternary ammonium, the carbonate, and the hydroxide are used as basic compounds, the use ratio of these components is not particularly limited, and can fall within an appropriate range that provides good balance between maintenance of a polishing removal rate and a bump cancellation property corresponding to the content or concentration of an abrasive or another component and the like.

The content of a basic compound relative to the total amount of a polishing composition is preferably 0.005% by weight or more, more preferably 0.01% by weight or more, and may be 0.03% by weight or more, 0.05% by weight or more, 0.1% by weight or more, 0.2% by weight or more, 0.5% by weight or more, or 1% by weight or more. Increase in the content of a basic compound leads to a tendency of improvement in a polishing removal rate. The upper limit of the content of a basic compound is suitably 7% by weight or less. In view of promoting dissolution of a chelating agent by setting the concentration of a solute in the chelating agent-containing liquid to a certain level or less, and in view of surface quality or the like, the upper limit is preferably 5% by weight or less, more preferably 3% by weight or less, and may be 2.5% by weight or less, 1.5% by weight or less, 1.0% by weight or less, or 0.7% by weight or less. When two or more kinds of basic compounds are used in combination, the content refers to the total content of the two or more kinds of basic compound. These contents can be preferably applied to, e.g., a content in a polishing slurry (working slurry) to be supplied to an object to be polished.

In the case of a polishing composition to be diluted and used for polishing (i.e., a concentrate), the content of a basic compound is usually, suitably 10% by weight or less, more preferably 5% by weight or less (e.g., 4% by weight or less), in view of storage stability, filterability, and the like. Meanwhile, in view of leveraging advantage of a concentrate, the content of a basic compound is preferably 0.1% by weight or more, more preferably 0.5% by weight or more, more preferably 0.9% by weight or more, and may be 1.5% by weight or more, or 2% by weight or more.

The weight ratio (C_{B}/C_{A}) of the content of a basic compound C_{B} relative to the content of an abrasive C_{A} in a polishing composition is not particularly limited, as long as an effect of the art disclosed herein is exerted. The ratio (C_{B}/C_{A}) is, e.g., suitably about 0.005 or more, and in view of effectively exerting an effect of addition of a basic compound, it is preferably 0.01 or more, more preferably 0.02 or more, and may be, e.g., 0.05 or more. Meanwhile, in view of mechanical polishing with an abrasive, dispersion stability of a composition, and the like, the ratio (C_{B}/C_{A}) is, e.g., suitably about 3 or less, preferably 2 or less, more preferably 1.5 or less, and may be 1 or less, 0.5 or less, 0.3 or less, or 0.2 or less (e.g., 0.1 or less).

### <Chelating Agent>

A chelating agent used for production of a polishing composition by the method disclosed herein can be suitably selected from known chelating agents in the art of polishing compositions. The chelating agent may be used singly or in combination of two or more kinds thereof. Examples of the chelating agent include an aminocarboxylic acid-based chelating agent and an organic phosphonic acid-based chelating agent.

Examples of the aminocarboxylic acid-based chelating agent include alanine, glycine, aspartic acid (Asp), nitrilotriacetic acid, ethylenediamine tetraacetic acid (EDTA), diethylenetriamine pentaacetic acid (DTPA), triethylenetetramine hexaacetic acid (TTHA), ethylenebisimino bis(2-hydroxyphenyl)acetic acid (EDDHA), and hydroxyethylethylenediamine triacetic acid. The aminocarboxylic acid-based chelating agent may be used in an acid form or in a salt form. Examples of the salt include alkali metal salts (e.g., sodium salts) and ammonium salts. Accordingly, examples of the aminocarboxylic acid-based chelating agent include sodium nitrilotriacetate, ammonium nitrilotriacetate, sodium ethylenediamine tetraacetate, sodium diethylenetriamine pentaacetate, sodium triethylenetetramine hexaacetate, and sodium hydroxyethylethylenediamine triacetate.

Examples of the organic phosphonic acid-based chelating agent include 2-aminoethylphosphonic acid, 1-hydroxyethylidene-1,1-diphosphonic acid (HEDP), aminotri(methylenephosphonic acid), ethylenediamine tetrakis(methylenephosphonic acid) (EDTPO), diethylenetriamine-penta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, phosphonobutane-tricarboxylic acid (PBTC), nitrilotris(methylenephosphonic acid) (NTMP), and α-methylphosphonosuccinic acid. The organic phosphonic acid-based chelating agent may be used in an acid form or in a salt form (e.g., alkali metal salts such as sodium salts, and ammonium salts) in the same manner as the aminocarboxylic acid-based based chelating agent.

In some preferred embodiment, an acid form of a chelating agent is used as a part (e.g., more than 50% by mole, more than 75% by mole, more than 90% by mole, or more than 95% by mole of the total of a chelating agent) or all of a chelating agent used for preparing a polishing composition. Use of an acid form of a chelating agent is advantageous in view of lowering alkali metal in a polishing composition.

In some preferred embodiment, in view of performance of trapping metal ions, a chelating agent that is an n-valent acid (n≥2) is used as a part (e.g., more than 50% by mole, more than 75% by mole, more than 90% by mole, or more than 95% by mole of the total of a chelating agent) or all of a chelating agent used for preparing a polishing composition. More preferred is a chelating agent in which the n is 3 or more, even more preferred is a chelating agent in which the n is 4 or more, and particularly preferred is a chelating agent in which the n is 5 or more (i.e., a pentavalent or more chelating agent). The upper limit of the n is not particularly limited. In some embodiments, in view of dispersion stability of a polishing composition and the like, the n is suitably 15 or less, preferably 12 or less, more preferably 10 or less (e.g., 8 or less). A chelating agent in which the n is a predetermined value or more can be appropriately selected from known chelating agents including the aforementioned specific examples. For example, specific examples of a chelating agent in which the n is 5 or more include, but are not limited to, DTPA (pentavalent), TTHA (hexavalent), and EDTPO (octavalent).

In some embodiments, as the chelating agent that is an n-valent acid (n≥2), a compound can be preferably used that has a pKaₙ₋₁ of more than 7.0 as the acid dissociation constant pKa of the chelating agent is defined as pKa₁ to pKaₙ in order of increasing numerical values. To explain with DTPA as an example, DTPA is a pentavalent acid (i.e., n=5) with a pKa₅ (pKaₙ) of 10.53 and a pKa₄ (pKaₙ₋₁) of 8.6, and thus satisfies the requirements of an n-valent acid (n≥2) and a pKaₙ₋₁ of more than 7.0. Specific examples of a chelating agent satisfying such requirements include, but are not limited to, DTPA, TTHA, EDTPO, and EDDHA, and a chelating agent satisfying the requirements can be appropriately selected and used from known chelating agents. As an acid dissociation constant pKa, a manufacturer's nominal value (catalogue value) can be employed. For example, a value described in the catalogue of Dojindo Laboratories can be employed.

In view of facilitating satisfying pH_{ch} > pKaₙ₋₁ in the relationship with the pH of a chelating agent-containing liquid described later (pH_{ch}), the pKaₙ₋₁ of a chelating agent used for production of a polishing composition is suitably 12 or less, preferably 11 or less, more preferably 10 or less, in some embodiments. Additionally, there is a tendency that as the valence of an acid used as a chelating agent (the n) is larger, the value of pKaₙ₋₁ is generally higher. In view of facilitating exerting advantage caused by use of a high-valent chelating agent, the pKaₙ₋₁ of a chelating agent is preferably 7.5 or more, more preferably 8.0 or more, even more preferably 8.5 or more, in some embodiments.

Preferred examples of the aminocarboxylic acid-based chelating agent include EDTA, DTPA, TTHA, and EDDHA. In particular, preferred are DTPA, TTHA, and EDDHA, and particularly preferred are DTPA and TTHA. An particularly preferred organic phosphonic acid-based chelating agent is EDTPO.

The content of a chelating agent in a polishing composition can be, e.g., 0.001 mM or more (i.e., 0.001 millimole/liter or more), and in some embodiments, it is preferably 0.005 mM or more, more preferably 0.01 mM or more, and may be, e.g., 0.05 mM or more, 0.1 mM or more, 0.5 mM or more, 1.0 mM or more, 1.5 mM or more, or 2.0 mM or more. Increase in the content of a chelating agent in a polishing composition [unit: mM] allows improvement in metal trapping per volume of the polishing composition. This is preferred, e.g., in view of reducing exchange frequency of a polishing composition (polishing slurry) in polishing in an embodiment of circulative use of the polishing composition. Meanwhile, the content of a chelating agent in a polishing composition can be, e.g., 250 mM or less, and in view of facilitating providing good dissolution of the chelating agent, it is suitably 100 mM or less, preferably 50 mM or less, more preferably 20 mM or less, and may be 10 mM or less, 5 mM or less, or 3 mM or less, in some embodiments.

Additionally, in the case of a polishing composition to be diluted and used for polishing (i.e., a concentrate), the content of a chelating agent in the concentrate can be, e.g., 0.01 mM or more, and in view of leveraging advantage of a concentrate, it is preferably 0.05 mM or more, more preferably 0.1 mM or more, and may be 0.5 mM or more, 1 mM or more, 3 mM or more, or 5 mM or more. Meanwhile, the content of a chelating agent in the concentrate can be, e.g., 500 mM or less, and in view of facilitating providing good dissolution of the chelating agent, it is suitably 200 mM or less, preferably 100 mM or less, more preferably 50 mM or less, and may be 30 mM or less, 20 mM or less, or 15 mM or less, in some embodiments.

### <Water>

A polishing composition disclosed herein contains water. Examples of water include ion-exchanged water (deionized water), pure water, ultrapure water, and distilled water. In water to be used, the content of transition metal ions is preferably, e.g., 100 ppb or less in total, in order to avoid inhibiting a function of another component in the polishing composition as much as possible. For example, water can have improved purity by removal of impurity ions by ion-exchange resin, removal of contaminants by a filter, distillation, or the like.

A polishing composition disclosed herein may further contain an organic solvent that can be uniformly mixed with water (lower alcohol, lower ketone, or the like), as appropriate. Usually, in a solvent(s) in the polishing composition, water preferably accounts for 90% by volume or more, more preferably 95% by volume or more (e.g., 99 to 100% by volume).

### <Water-soluble Polymer>

A polishing composition produced by the method disclosed herein may include a water-soluble polymer as an optional component. The water-soluble polymer can serve improvement of a polished surface quality and increase in a bump cancellation property on a periphery of HLM in stock polishing of a silicon wafer having HLM.

Examples of the water-soluble polymer include cellulose derivatives, starch derivatives, oxyalkylene unit-containing polymer, nitrogen atom-containing polymer, and vinyl alcohol-based polymer. Specific examples include hydroxyethyl cellulose, pullulan, random copolymer or block copolymer of ethylene oxide and propylene oxide, unmodified polyvinyl alcohol, modified polyvinyl alcohol (e.g., acetalized polyvinyl alcohol), polyisoprene sulfonic acid, polyvinyl sulfonic acid, polyallyl sulfonic acid, polyisoamylene sulfonic acid, polystyrene sulfonic acid salt, styrenemaleic acid copolymer, polyacrylic acid salt, polyvinyl acetate, polyethylene glycol, polyvinyl imidazole, polyvinyl carbazole, polyvinylpyrrolidone, polyacryloyl morpholine, polyvinyl caprolactam, and polyvinyl piperidine. The water-soluble polymer can be used singly or in combination of two or more kinds thereof.

In the art disclosed herein, the molecular weight of the water-soluble polymer is not particularly limited. For example, the weight-average molecular weight (Mw) of the water-soluble polymer can be about 200 × 10⁴ or less, and is suitably 150 × 10⁴ or less. In view of preventing polishing vibration, surface defects, and the like, the Mw may be about 100 × 10⁴ or less, or about 50 × 10⁴ or less. Meanwhile, in view of protectivity of a surface of a silicon wafer, the Mw is usually, about 0.2 × 10⁴ or more, suitably about 0.5 × 10⁴ or more, and may be about 0.8 × 10⁴ or more.

As the Mw of the water-soluble polymer, a value based on aqueous gel permeation chromatography (GPC) (aqueous phase, on polyethylene oxide conversion basis) can be employed.

Without particular limitation, the total amount of the water-soluble polymer (the sum of contents if two or more kinds of water-soluble polymers are contained) relative to the total weight of a polishing composition can be, e.g., 1.0 × 10⁻⁷% by weight or more, and is suitably 1.0 × 10⁻⁶% by weight or more, and in some preferred embodiments, it may be 1.0 × 10⁻⁵% by weight or more, 5.0 × 10⁻⁵% by weight or more, 1.0 × 10⁻⁴% by weight or more, 2.0 × 10⁻⁴% by weight or more, or 3.0 × 10⁻⁴% by weight or more. Meanwhile, in view of maintaining a polishing removal rate, the total amount of the water-soluble polymer can be, e.g., 0.5% by weight or less, and is suitably 0.1% by weight or less, and in some preferred embodiments, it may be 0.05% by weight or less, 0.01% by weight or less, 0.005% by weight or less, 0.001% by weight or less, or 0.0005% by weight or less. No water-soluble polymer may be used.

In the case of a polishing composition (i.e., a concentrate) to be diluted and used for polishing, the total amount of the water-soluble polymer can be, e.g., 1.0 × 10⁻⁶% by weight or more, is suitably 1.0 × 10⁻⁵% by weight or more, and may be 1.0 × 10⁻⁴% by weight or more, 1.0 × 10⁻³% by weight or more, or 5.0 × 10⁻³% by weight or more. Meanwhile, in view of storage stability, filterability, and the like, the total amount of the water-soluble polymer can be, e.g., 5% by weight or less, is suitably 1% by weight or less, preferably 0.5% by weight or less, and may be 0.1% by weight or less, or 0.05% by weight or less.

The total amount of the water-soluble polymer (the sum of contents if two or more kinds of water-soluble polymers are contained) in the polishing composition can be, e.g., 0.0001 parts by weight or more and is suitably 0.001 parts by weight or more relative to 100 parts by weight of an abrasive, and in some preferred embodiments, it may be 0.005 parts by weight or more, 0.01 parts by weight or more, 0.02 parts by weight or more, 0.05 parts by weight or more, or 0.1 parts by weight or more. Meanwhile, in view of dispersion stability, the total amount of the water-soluble polymer relative to 100 parts by weight of an abrasive may be, e.g., 10 parts by weight or less, or 5 parts by weight or less. In view of maintaining a polishing removal rate, the total amount of the water-soluble polymer relative to 100 parts by weight of an abrasive is suitably 3 parts by weight or less, and may be 2 parts by weight or less, 1 part by weight or less, 0.1 parts by weight or less, or 0.05 parts by weight or less, in some preferred embodiments.

### <Other components>

A polishing composition produced by the method disclosed herein may further contain, as appropriate, a known additive that can be used for a polishing composition (e.g., a polishing composition used for a polishing step of a silicon wafer), such as an inorganic acid salt, an organic acid salt, a surfactant, an antiseptic agent, or an antifungal agent, as far as an effect of the present invention is not significantly inhibited.

Examples of the inorganic acid salt include salts of hydrohalic acids (e.g., hydrochloric acid, hydrobromic acid, hydroiodic acid, and hydrofluoric acid), nitric acid, sulfuric acid, sulfurous acid, hydrogen sulfite, thiosulfuric acid, silicic acid, boric acid, and phosphoric acid. Examples of the organic acid salt include salts of carboxylic acid (e.g., formic acid, acetic acid, propionic acid, benzoic acid, butyric acid, and trifluoroacetic acid), organic sulfonic acid (e.g., methanesulfonic acid, trifluoromethanesulfonic acid, benzenesulfonic acid, toluenesulfonic acid), sulfamic acid, and organic phosphoric acid (e.g., ethyl phosphoric acid). Without particular limitation, examples of a cation forming the inorganic acid salt and the organic acid salt include alkali metals (lithium, sodium, potassium, and the like), alkaline earth metals (calcium, strontium, barium, and the like), magnesium, and ammonium. In some embodiments, specific examples of salts of sulfuric acid (sulfate) include lithium sulfate, sodium sulfate, potassium sulfate, and ammonium sulfate. Herein, the inorganic acid salt and the organic acid salt do not encompass the aforementioned basic compound. Furthermore, herein, the organic acid salt does not encompass the aforementioned chelating agent.

The surfactant may be used singly or in combination of two or more kinds thereof. Without particular limitation, examples of the surfactant include anionic surfactants, nonionic surfactants, cationic surfactants, and amphoteric surfactants. Use of the surfactant (e.g., a water-soluble organic compound having a molecular weight of less than 0.2 × 10⁴) can improve dispersion stability of a polishing composition. As the Mw of the surfactant, a value derived by GPC (aqueous phase, on polyethylene glycol conversion basis) or a value calculated from a chemical formula can be employed.

In some embodiments, a polishing composition has a composition with a limited usage of the surfactant. The content of the surfactant in a polishing composition (e.g., polishing slurry) may be less than 0.3% by weight, less than 0.1% by weight, less than 0.05% by weight, less than 0.005% by weight, or less than 0.0005% by weight. The art disclosed herein can be preferably performed in an embodiment in which a polishing composition contains substantially no surfactant, i.e., in an embodiment of not containing any surfactant at least intentionally.

Examples of the antiseptic agent and antifungal agent include isothiazoline-based compounds, paraoxybenzoic acid esters, and phenoxyethanol.

A polishing composition produced by the method disclosed herein preferably contains substantially no oxidant. This is because when the polishing composition contains an oxidant, supply of the composition can cause oxidation on a surface formed of a silicon material (e.g., a silicon wafer surface) and generate an oxide layer, thereby reducing a polishing removal rate. As used herein, the phrase "polishing composition contains substantially no oxidant" means that an oxidant is not blended at least intentionally, and it can be acceptable to inevitably contain a slight amount of an oxidant originated from a raw material and a production method. The slight amount means that the molar concentration of an oxidant in a polishing composition is 0.001 mol/L or less (preferably 0.0005 mol/L or less, more preferably 0.0001 mol/L or less, even more preferably 0.00005 mol/L or less, particularly preferably 0.00001 mol/L or less). In some preferred embodiments, a polishing composition contains no oxidant. A polishing composition disclosed herein can be preferably implemented in an embodiment of containing e.g., none of hydrogen peroxide, sodium persulfate, ammonium persulfate, and sodium dichloroisocyanurate.

### <Production method of Polishing Composition>

The production method of a polishing composition disclosed herein is performed with use of the silica particles, the basic compound, the chelating agent and water as described above, and as appropriate, with further use of an optional component. The production method includes preparing a basic chelating agent-containing liquid, and mixing the chelating agent-containing liquid and a silica dispersion.

### (Chelating Agent-containing Liquid)

The chelating agent-containing liquid contains a basic compound, water, and a chelating agent. A basic compound in the chelating agent-containing liquid may occupy a partial quantity of a basic compound used for production of a polishing composition (i.e., a basic compound in a polishing composition to be produced), or substantially all quantity thereof (e.g., 97% by weight or more, 99% by weight or more, or 100% by weight of the total of a basic compound in the polishing composition). The partial quantity can be, e.g., 1% by weight or more, 5% by weight or more, 10% by weight or more, 25% by weight or more, 35% by weight or more, 50% by weight or more, 75% by weight or more, 85% by weight or more, or 95% by weight or more of a basic compound used for production of a polishing composition. In an embodiment of producing a polishing composition containing a plurality kinds of basic compounds, basic compounds in the chelating agent-containing liquid may be all or some kinds of basic compounds used for the polishing composition. Additionally, the chelating agent-containing liquid may contain a partial quantity of one or some kinds, substantially all quantity of one or some kinds, or a combination thereof, or all quantity of all kinds, among a plurality kinds of basic compounds used for production of a polishing composition.

When the chelating agent-containing liquid does not contain one or some certain kinds and/or a partial quantity of a basic compound(s) used for production of a polishing composition, the remaining basic compound(s) may be, e.g., added to a mixture of the chelating agent-containing liquid and the silica dispersion after preparation of the mixture, or may be mixed, as a constituent component of the silica dispersion, with the chelating agent-containing liquid.

The pH of the chelating agent-containing liquid (referring to a pH just before mixing with the silica dispersion and hereinafter sometimes represented by "pH_{ch}") can be more than 7, e.g., 8 or more. In some embodiments, the pH of the chelating agent-containing liquid is suitably 9 or more, and may be 10 or more, preferably 10.5 or more, more preferably 11 or more, and may be 11.5 or more, 12 or more, or 12.5 or more. It is preferred to provide the chelating agent-containing liquid with high pH, in view of solubility of a chelating agent in the chelating agent-containing liquid. The upper limit of the pH of the chelating agent-containing liquid is not particularly limited, and usually 14 or less. As long as a chelating agent can be sufficiently well dissolved, the pH of the chelating agent-containing liquid may be, e.g., 13.5 or less, 13 or less, 12 or less, or 11 or less. The pH of the chelating agent-containing liquid can be adjusted by the kind, concentration, or the like of a component (particularly, a basic compound) in the chelating agent-containing liquid. The pH of the chelating agent-containing liquid is measured in the same manner as for the pH of a polishing composition described later.

In some embodiments, the pH of the chelating agent-containing liquid (pH_{ch}) can be higher than the pH of a polishing composition, which is a resultant of production with use of the chelating agent-containing liquid (hereinafter also referred to as "pH_{R}"). This is advantageous in view of ease of preparing the chelating agent-containing liquid with a chelating agent well-dissolved. A difference between pH_{ch} and pH_{R} (pH_{ch} - pH_{R}) may be, e.g., 0.1 or more, is usually, suitably 0.5 or more, preferably 1 or more, more preferably 1.5 or more, and may be 2 or more, 2.5 or more, or 3 or more.

In some embodiments, when the chelating agent-containing liquid is used with containing the aforementioned chelating agent that is an n-valent acid (n≥2), the pH of the chelating agent-containing liquid (pH_{ch}) is preferably higher than the pKaₙ₋₁ of the chelating agent (i.e., preferably satisfies pH_{ch} > pKaₙ₋₁), more preferably higher than the pKaₙ of the chelating agent, in view of solubility of the chelating agent.

The content of a basic compound in the chelating agent-containing liquid can be determined so as to provide the pH of the chelating agent-containing liquid within a suitable range in consideration of the kind of the basic compound and the like, and can fall within about 0.001% by weight to 25% by weight. In some embodiments, the content of a basic compound in the chelating agent-containing liquid is suitably 0.005% by weight or more, and in view of promoting dissolution of a chelating agent, it may be 0.01% by weight or more, preferably 0.05% by weight or more, more preferably 0.1% by weight or more, and may be 0.2% by weight or more. Meanwhile, in some embodiments, the content of a basic compound in the chelating agent-containing liquid is e.g., suitably 15% by weight or less, preferably 10% by weight or less, and may be 8% by weight or less, 6% by weight or less, 4% by weight or less, 2% by weight or less, or 1% by weight or less.

Additionally, in production of a polishing composition (i.e., a concentrate) to be diluted and used for polishing, the content of a basic compound of the chelating agent-containing liquid used for production of the concentrate is, e.g., suitably 0.1% by weight or more, preferably 0.3% by weight or more, and may be 1% by weight or more, or 2% by weight or more, in some embodiments. Meanwhile, the content of a basic compound of the chelating agent-containing liquid used for production of the concentrate may be, e.g., 25% by weight or less, 24% by weight or less, 20% by weight or less, or 15% by weight or less.

A chelating agent in the chelating agent-containing liquid may occupy a partial quantity of a chelating agent used for production of a polishing composition, or substantially all quantity thereof (e.g., 97% by weight or more, 99% by weight or more, or 100% by weight of the total of a chelating agent in the polishing composition). In view of increasing an effect from application of the present invention, it is preferred that 80% by weight or more, preferably 90% by weight or more, even more preferably substantially all of a chelating agent in a polishing composition be contained in the chelating agent-containing liquid. This allows at least most quantity of a chelating agent used for production of a polishing composition to be easily checked for a level of dissolution of the chelating agent before generation of turbidity of a system due to mixing with the silica dispersion. Checking of a level of dissolution of the chelating agent can be performed by, e.g., visually observing the chelating agent-containing liquid, which contains the chelating agent.

The content of a chelating agent in the chelating agent-containing liquid can be determined in consideration of a target concentration of a chelating agent in a polishing composition to be produced, solubility of the chelating agent, and the like, and is not particularly limited. In some embodiments, the content of a chelating agent in the chelating agent-containing liquid can be, e.g., 0.005 mM or more, and in some embodiments, it is preferably 0.01 mM or more, more preferably 0.05 mM or more, and may be, e.g., 0.1 mM or more, 0.3 mM or more, 0.7 mM or more, 1.0 mM or more, 1.5 mM or more, or 2.0 mM or more. Meanwhile, the content of a chelating agent in the chelating agent-containing liquid can be, e.g., 500 mM or less, and in view of facilitating providing good dissolution of the chelating agent, it is suitably 150 mM or less, preferably 100 mM or less, more preferably 50 mM or less, and may be 30 mM or less, 10 mM or less, or 5 mM or less, in some embodiments.

Additionally, in some embodiments of producing a polishing composition (i.e., a concentrate) to be diluted and used for polishing, the content of a chelating agent in the chelating agent-containing liquid can be, e.g., 0.01 mM or more, preferably 0.05 mM or more, more preferably 0.1 mM or more, and may be 0.5 mM or more, 1 mM or more, 3 mM or more, or 5 mM or more. Meanwhile, the content of a chelating agent in the chelating agent-containing liquid used for production of the concentrate can be, e.g., 1000 mM or less, and in view of facilitating providing good dissolution of the chelating agent, it is suitably 700 mM or less, preferably 500 mM or less, more preferably 300 mM or less, and may be 200 mM or less, 100 mM or less, 50 mM or less, 30 mM or less, 20 mM or less, or 10 mM or less, in some embodiments.

The chelating agent-containing liquid preferably has a limited content of silica particles in the chelating agent-containing liquid in view of ease of checking a level of dissolution of a chelating agent as described above. When the chelating agent-containing liquid is used for production of a polishing composition having a composition with combination of silica particles and non-silica particles as abrasives, it is preferred that the total content of the silica particles and the non-silica particles be limited; that is, the chelating agent-containing liquid in the production method disclosed herein preferably has a limited content of an abrasive(s). In some embodiments, the content of an abrasive in the chelating agent-containing liquid is suitably less than 0.005% by weight, preferably less than 0.001% by weight, more preferably less than 0.0005% by weight, even more preferably less than 0.0001% by weight. In some preferred embodiment, the chelating agent-containing liquid contains no abrasive .

The chelating agent-containing liquid can be prepared by mixing a basic compound, water, and a chelating agent. The mixing order thereof is not particularly limited; for example, a chelating agent may be added to a mixture of a basic compound and water, or a basic compound may be added to a mixture of a chelating agent and water. A mixture of a certain component and water, in this context, is a concept that encompasses an aqueous solution, water dispersion, and the like of the component. Each component may be added sorely or as a mixture with another component (e.g., water), and may also be added simultaneously with 2 or more components.

### (Silica Dispersion)

The silica dispersion contains silica particles and water. In view of ease of preparation, mixability with another component, and the like, the content of silica particles in the silica dispersion is usually, suitably 50% by weight or less, preferably 45% by weight or less, and may be 40% by weight or less, 35% by weight or less, 30% by weight or less, 20% by weight or less, 10% by weight or less, or 5% by weight or less. The lower limit of the content of silica particles in the silica dispersion is set so as to provide a desired content of silica particles in a polishing composition to be produced, and is usually, suitably equal to or more than the content of silica particles in the polishing composition. For example, in an embodiment of producing a polishing composition (i.e., a concentrate) to be diluted and used for polishing, the content of silica particles in the silica dispersion is preferably more than 1% by weight, more preferably more than 5% by weight, and may be 10% by weight or more, or 15% by weight or more.

The pH of the silica dispersion (indicating a pH just before mixing with the chelating agent-containing liquid, i.e., pH_{Si}) may be, e.g., 6 or more, and is usually, suitably 6.4 or more in terms of dispersion stability of silica particles, preferably 7 or more (e.g., above 7) in view of ease of maintaining a basic pH of a mixture with the chelating agent-containing liquid. In some embodiments, the pH of the silica dispersion may be, e.g., 7.5 or more, 8 or more, 9 or more, 10 or more, 11 or more, or 12 or more. Meanwhile, the pH of the silica dispersion may be, e.g., 14 or less, in view of preventing dissolution of silica particles, it is preferably 13.5 or less, more preferably 13 or less, and may be 12.5 or less, 11.5 or less, 10.5 or less, 9.5 or less, or 8.5 or less. The pH of the silica dispersion is measured in the same manner as for the pH of a polishing composition described later.

A relationship between the pH_{ch} of the chelating agent-containing liquid and the pH_{Si} of the silica dispersion is not particularly limited, and may be pH_{ch} < pH_{Si}, pH_{ch} > pH_{Si}, or pH_{ch} = pH_{Si}. In view of better leveraging advantage from preliminary preparation of a chelating agent-containing liquid containing at least a part of a chelating agent and a basic compound prior to mixing with the silica dispersion, a difference (pH_{ch} - pH_{Si}) is suitably 0.1 or more, preferably 0.5 or more, more preferably 1 or more, even more preferably 1.5 or more, and may be 2 or more, 3 or more, or 4 or more, in some embodiments.

Mixing of the chelating agent-containing liquid and the silica dispersion may be performed in an embodiment of adding the silica dispersion to the chelating agent-containing liquid, may be performed in an embodiment of adding the chelating agent-containing liquid to the silica dispersion, or may be performed in an embodiment of adding both simultaneously. In production of a polishing composition containing optional components as described above (e.g., a water-soluble polymer and a surfactant), each of the optional components may be contained in the chelating agent-containing liquid, may be contained in the silica dispersion, may be added after mixing of the chelating agent-containing liquid and the silica dispersion, or may be added simultaneously with mixing of the chelating agent-containing liquid and the silica dispersion.

Preparation of each of the chelating agent-containing liquid and the silica dispersion, mixing of the chelating agent-containing liquid and the silica dispersion, addition of another component, and the like can be performed by a known method, using a well-known mixing device such as a blade stirrer, an ultrasonic disperser, or a homomixer.

### <Polishing Composition>

A polishing composition produced by the method disclosed herein is supplied to an object to be polished in form of, e.g., a polishing slurry (working slurry) containing the polishing composition, and used for polishing of the object to be polished. The polishing slurry can be prepared by e.g., diluting a concentrate of a polishing composition produced by any method disclosed herein (e.g., diluting with water). Alternatively, the polishing composition may be used directly as a polishing slurry. The concentration factor of the concentrate may be, e.g., about 2-fold to 140-fold on volume basis, and is usually, suitably about 5-fold to 80-fold.

The pH of the polishing composition is, e.g., 8.0 or more, preferably 8.5 or more, more preferably 9.0 or more, even more preferably 9.5 or more, and may be 10.0 or more (e.g., 10.5 or more). As the pH is higher, a polishing removal rate tends to improve. Meanwhile, in view of preventing dissolution of an abrasive (e.g., silica particles) and curbing reduction in mechanical polishing action caused by the abrasive, the pH of the polishing composition is usually, suitably 12.0 or less, preferably 11.8 or less, more preferably 11.5 or less. These pHs can be preferably applied to both of the pHs of a polishing slurry (working slurry) to be supplied to an object to be polished and a concentrate thereof.

The pH of the polishing composition can be known by performing three-point calibration with standard buffers (a phthalate pH buffer with pH 4.01 (25°C), a neutral phosphate pH buffer with pH 6.86 (25°C), and a carbonate pH buffer with pH 10.01 (25°C)) using a pH meter (e.g., a glass-electrode hydrogen ion concentration indicator (model: F-23) manufactured by Horiba, Ltd.), then inserting a glass electrode into the polishing composition, leaving it to stand for 2 minutes or more until stabilization and then measuring a value.

A polishing composition disclosed herein may be a single-agent type or a multi-agent type such as a two-agent type. For example, the composition may be configured to prepare a polishing slurry by mixing of Part A, which contains at least an abrasive, and Part B, which contains at least a part of the remaining components, and diluting them at an appropriate timing, as appropriate. Part A described above may be, e.g., the aforementioned silica dispersion, a concentrate to be diluted and used as a silica dispersion, or the like. Part B described above may be, e.g., the aforementioned chelating agent-containing liquid, a concentrate to be diluted and used as a chelating agent-containing liquid, or the like. Part A and Part B may be separately and independently mixed after treatment such as dilution, pH adjustment, or addition of another component, or the like, and the treatment may be performed after mixing Part A and Part B.

### <Polishing>

A polishing composition produced by the method disclosed herein can be used for polishing of an object to be polished, e.g. in an embodiment including the operation as below.

In other words, a working slurry containing the polishing composition is provided. Then, the polishing composition is supplied to an object to be polished, and polishing is carried out by a common method. For example, an object to be polished is set in a typical polishing machine, and then the polishing composition is supplied via a polishing pad of the polishing machine onto a surface of the object to be polished (a surface to be polished). For example, while the polishing composition is consecutively supplied, a polishing pad is pushed against the surface of the object to be polished and both are relatively moved (e.g., rotatably moved). Through such a polishing step, polishing of the object to be polished is completed.

A polishing pad used in the polishing step is not particularly limited. For example, any of a foamed polyurethane type, a non-woven fabric type, a suede type, and the like, with or without containing an abrasive may be used. In some preferred embodiments, a polishing pad having no abrasive is used. As the polishing machine, a double-sided polishing machine that polishes simultaneously both sides of an object to be polished may be used, or an one-sided polishing machine that polishes only one side of an object to be polished may be used.

The polishing composition may be used in an embodiment in which it is used once for polishing and then thrown away (so-called "one-way"), or may be recycled and used repeatedly. An exemplary method of circulative use of a polishing composition is a method of recovering a used polishing composition discharged from a polishing machine into a tank and supplying again the recovered polishing composition to the polishing machine.

### <Application>

A polishing composition produced by the method disclosed herein is used for polishing of a surface formed of a silicon material, preferably used for stock polishing of a surface formed of a silicon material. As the silicon material, at least one kind selected from the group consisting of silicon single crystal, amorphous silicon, or polysilicon is preferably contained. The polishing composition is particularly preferred in polishing of a surface formed of silicon single crystal (e.g., a silicon wafer). The polishing composition can also be applied to polishing of a surface to be polished including a surface provided with HLM. A polishing composition disclosed herein can be particularly preferably used in a stock polishing step, more particularly in a rough polishing step that is a first polishing step in a polishing step (stock polishing step), a subsequent intermediate polishing step (secondary polishing step).

The silicon wafer may experience a typical treatment that can be applied to a silicon wafer, such as lapping, etching, or provision of HLM described above, before a polishing step using a polishing composition disclosed herein.

The silicon wafer has a surface formed of, e.g., silicon. Such a silicon wafer is preferably a silicon single crystal wafer, such as a silicon single crystal wafer derived by slicing a silicon single crystal ingot. A polishing composition disclosed herein is preferred for application of polishing a silicon single crystal wafer provided with HLM.

A polishing composition disclosed herein can be also preferably used in polishing of an object to be polished having no HLM.

The items disclosed herein include the followings.
[1] A method of producing a polishing composition for polishing a surface formed of a silicon material including:
   preparing a basic chelating agent-containing liquid containing a basic compound, water, and a chelating agent; and
   mixing a silica dispersion containing silica particles and water, and the chelating agent-containing liquid.
[2] The production method set forth in the item [1], wherein the pH of the silica dispersion to be mixed with the chelating agent-containing liquid is 6 or more and 14 or less.
[3] The production method set forth in any of the item [1] or [2],
   wherein the chelating agent is an n-valent acid (n≥2), and
   wherein pKaₙ₋₁ is more than 7.0 as the acid dissociation constant pKa of the chelating agent is defined as pKa₁ to pKaₙ in order of increasing numerical values.
[4] The production method set forth in any of the items [1] to [3], containing a pentavalent or more chelating agent as the chelating agent.
[5] The production method set forth in any of the items [1] to [4], wherein the polishing composition is a polishing composition for stock polishing of the surface formed of the silicon material.
[6] The production method set forth in any of the items [1] to [5], including acquiring a level of dissolution of the chelating agent in the chelating agent-containing liquid prior to mixing of the silica dispersion and the chelating agent-containing liquid.
[7] A polishing composition produced by the production method set forth in any of the items [1] to [6].

Several examples relating to the present invention will be described below, but the present invention is not intended to be limited to the embodiments shown in the examples.

### <Abbreviation List>

### [Basic Compound]

TMAH: tetramethylammonium hydroxide
KOH: potassium hydroxide
K₂CO₃: potassium carbonate

### [Chelating Agent (acid valency, pKaₙ₋₁)]

EDTPO: ethylenediaminetetrakis(methylenephosphonic acid) (octavalent, 9.22)
DTPA: diethylenetriamine pentaacetic acid (pentavalent, 8.6)
TTHA: triethylenetetramine hexaacetic acid (hexavalent, 9.4)
EDDHA: ethylenebisiminobis[(2-hydroxyphenyl)acetic acid] (tetravalent, 10.7)
EDTA: ethylenediamine tetraacetic acid (tetravalent, 6.16)
Asp: aspartic acid (divalent, 3.9)
HEDP: 1-hydroxyethylidene-1,1-diphosphonic acid (tetravalent, 6.9)

### <<Experimental Example 1>>

### <Production of Polishing Composition>

### (Example 1)

A basic chelating agent-containing liquid with 0.35% by weight of TMAH and 2.62 mM of EDTPO was prepared by adding EDTPO to an aqueous solution of TMAH and mixing together.

To the chelating agent-containing liquid was added a silica dispersion having a pH of 7.5 and containing sol-gel-derived silica (average secondary particle diameter: 49 nm) as silica particles (hereinafter referred to as "Silica dispersion A") and K₂CO₃ in this order, thereby producing a polishing composition with a final composition as follows: 2% by weight of silica particles, 0.3% by weight of TMAH, 2% by weight of K₂CO₃, and 2.25 mM of EDTPO.

### (Example 2)

A basic chelating agent-containing liquid with 0.35% by weight of TMAH and 2.62 mM of EDTPO was prepared by adding an aqueous solution of TMAH to a mixture of EDTPO and water and mixing together.

To the chelating agent-containing liquid was added Silica dispersion A and K₂CO₃ in this order and mixed together, thereby producing a polishing composition having the same final composition as in Example 1.

### (Example 3)

A basic chelating agent-containing liquid with 0.33% by weight of TMAH, 2.2% by weight of K₂CO₃, and 2.47 mM of EDTPO was prepared by adding K₂CO₃ to an aqueous solution of TMAH, further adding EDTPO and mixing together.

To the chelating agent-containing liquid was added Silica dispersion A and mixed together, thereby producing a polishing composition having the same final composition as in Example 1.

### (Example 4)

A basic chelating agent-containing liquid with 0.33% by weight of TMAH, 2.2% by weight of K₂CO₃, and 2.47 mM of EDTPO was prepared by adding an aqueous solution of TMAH to a mixture of K₂CO₃ and water, further adding EDTPO and mixing together.

To the chelating agent-containing liquid was added Silica dispersion A and mixed together, thereby producing a polishing composition having the same final composition as in Example 1.

### (Example 5)

A basic chelating agent-containing liquid with 0.17% by weight of TMAH and 2.49 mM of EDTPO was prepared by adding EDTPO to an aqueous solution of TMAH and mixing together.

To the chelating agent-containing liquid was added Silica dispersion A and an aqueous solution of TMAH in this order, thereby producing a polishing composition with a final composition as follows: 2% by weight of silica particles, 0.3% by weight of TMAH, and 2.25 mM of EDTPO.

### (Example 6)

A basic chelating agent-containing liquid with 0.33% by weight of TMAH and 2.47 mM of EDTPO was prepared by adding EDTPO to an aqueous solution of TMAH and mixing together.

To the chelating agent-containing liquid was added Silica dispersion A and mixed together, thereby producing a polishing composition having the same final composition as in Example 5.

### (Example 7)

A basic chelating agent-containing liquid with 0.33% by weight of TMAH and 2.47 mM of EDTPO was prepared by adding an aqueous solution of TMAH to a mixture of EDTPO and water and mixing together.

To the chelating agent-containing liquid was added Silica dispersion A and mixed together, thereby producing a polishing composition having the same final composition as in Example 5.

### (Example 8)

A basic chelating agent-containing liquid with 0.17% by weight of TMAH and 2.48 mM of EDTPO was prepared by adding EDTPO to an aqueous solution of TMAH and mixing together. Meanwhile, a silica dispersion having a pH of 13.0 and containing 2.9% by weight of TMAH and 39% by weight of silica particles (hereinafter referred to as "Silica dispersion B") was prepared by adding an aqueous solution of TMAH to a silica dispersion containing sodium silicate-derived silica (average secondary particle diameter: 71 nm) as silica particles.

To the chelating agent-containing liquid was added Silica dispersion B and K₂CO₃ in this order, thereby producing a polishing composition with a final composition as follows: 2% by weight of silica particles, 0.3% by weight of TMAH, 2% by weight of K₂CO₃, and 2.25 mM of EDTPO.

### (Example 9)

A basic chelating agent-containing liquid with 0.18% by weight of TMAH and 2.64 mM of EDTPO was prepared by adding EDTPO to an aqueous solution of TMAH and mixing together. Meanwhile, a silica dispersion having a pH of 13.0 and containing 1.4% by weight of TMAH and 19% by weight of silica particles (hereinafter referred to as "Silica dispersion C") was prepared by adding an aqueous solution of TMAH to a silica dispersion containing sol-gel-derived silica (average secondary particle diameter: 35 nm) as silica particles.

To the chelating agent-containing liquid was added Silica dispersion C and K₂CO₃ in this order, thereby producing a polishing composition with a final composition as follows: 2% by weight of silica particles, 0.3% by weight of TMAH, 2% by weight of K₂CO₃, and 2.25 mM of EDTPO.

### (Comparative Examples 1 to 6)

A polishing composition having the same final composition as in Example 1 was produced by mixing Silica dispersion A, TMAH, K₂CO₃, and EDTPO in the order showing in Table 1.

### (Comparative Examples 7 and 8)

A polishing composition having the same final composition as in Example 5 was produced by mixing Silica dispersion A, TMAH, and EDTPO in the order showing in Table 1.

### <Evaluation>

### (Visibility of Dissolution of Chelating Agent)

In production processes of polishing compositions according to each of the examples and the comparative examples, whether a level of dissolution of a chelating agent can be checked visibly was evaluated. The results are shown in Table 1.

### [Table 1]

**Table 1**

| | Mixing order | | | | Visibility of dissolution of chelating agent |
|---|---|---|---|---|---|
| | 1 | 2 | 3 | 4 | |
| Example 1 | TMAH | EDTPO | Silica dispersion A | K₂CO₃ | V |
| Example 2 | EDTPO | TMAH | Silica dispersion A | K₂CO₃ | V |
| Example 3 | TMAH | K₂CO₃ | EDTPO | Silica dispersion A | V |
| Example 4 | K₂CO₃ | TMAH | EDTPO | Silica dispersion A | V |
| Example 5 | TMAH | EDTPO | Silica dispersion A | TMAH | V |
| Example 6 | TMAH | EDTPO | Silica dispersion A | - | V |
| Example 7 | EDTPO | TMAH | Silica dispersion A | - | V |
| Example 8 | TMAH | EDTPO | Silica dispersion B | K₂CO₃ | V |
| Example 9 | TMAH | EDTPO | Silica dispersion C | K₂CO₃ | V |
| Comparative Example 1 | Silica dispersion A | TMAH | K₂CO₃ | EDTPO | P |
| Comparative Example 2 | Silica dispersion A | TMAH | EDTPO | K₂CO₃ | P |
| Comparative Example 3 | Silica dispersion A | EDTPO | TMAH | K₂CO₃ | P |
| Comparative Example 4 | TMAH | Silica dispersion A | K₂CO₃ | EDTPO | P |
| Comparative Example 5 | K₂CO₃ | TMAH | Silica dispersion A | EDTPO | P |
| Comparative Example 6 | TMAH | K₂CO₃ | Silica dispersion A | EDTPO | P |
| Comparative Example 7 | Silica dispersion A | TMAH | EDTPO | - | P |
| Comparative Example 8 | TMAH | Silica dispersion A | EDTPO | - | P |

As shown in Table 1, in Examples 1 to 9, visible observation of a chelating agent-containing liquid prepared in each of the examples successfully provided sufficient confirmation that a chelating agent dissolved well into the chelating agent-containing liquid (visibility: V).

As Example 10, operations were performed up to mixing with K₂CO₃ in the same procedure as in Example 1, and then polyvinylpyrrolidone (PVP) with a weight-average molecular weight of 17,000 was further added and mixing together, thereby producing a polishing composition with a final composition as follows: 2% by weight of silica particles, 0.3% by weight of TMAH, 2% by weight of K₂CO₃, 2.25 mM of EDTPO, 0.005% by weight of PVP. At that time, visible observation of a chelating agent-containing liquid successfully provided sufficient confirmation that a chelating agent dissolved well in the same manner as in Example 1 (visibility: V).

By contrast, in Comparative Examples 1 to 8, in which a chelating agent was charged in a silica dispersion or a mixture of the silica dispersion and a basic compound rather than preparing a basic chelating agent-containing liquid beforehand, presence of silica particles prevents visual contact of a level of dissolution of the chelating agent charged (visibility: P). Further, as Comparative Example 9, a polishing composition was produced in the same manner as in Comparative Example 1 except for reducing a usage of Silica dispersion A so as to provide a content of 0.5% by weight of silica particles in a final composition (1/4 of the content in Comparative Example 1), and Comparative Example 9 thus obtained also demonstrated that presence of silica particles prevents visual contact of a level of dissolution of a chelating agent.

### <<Experimental Example 2>>

### <Production of Polishing Composition>

### (Examples 11 to 16)

A basic chelating agent-containing liquid with 0.35% by weight of TMAH and 2.62 mM of a chelating agent was prepared in the same manner as in Example 1 except for using a corresponding chelating agent shown in Table 2 instead of EDTPO.

To the chelating agent-containing liquid was added Silica dispersion A and K₂CO₃ in this order, thereby producing a polishing composition with a final composition as follows: 2% by weight of silica particles, 0.3% by weight of TMAH, 2% by weight of K₂CO₃, and 2.25 mM of a chelating agent.

### (Comparative Example 10)

A polishing composition was produced in the same manner as in Comparative Example 1 except for using no chelating agent, so as to have a final composition as follows: 2% by weight of silica particles, 0.3% by weight of TMAH, and 2% by weight of K₂CO₃.

### <Evaluation>

### (Visibility of Dissolution of Chelating Agent)

In production processes of polishing compositions according to Examples 11 to 16, whether a level of dissolution of a chelating agent can be checked visibly was evaluated in the same manner as in Experimental Example 1. The results are shown in Table 2.

### (Metallic Contamination Prevention Performance)

To a polishing composition produced by Examples 1 and 11 to 16 and Comparative Example 10 was added a Cu standard liquid (an aqueous solution of Cu•HNO₃, concentration: 1000 mg/L) or an Ni standard liquid (an aqueous solution of Ni•HNO₃, concentration: 1000 mg/L), thereby providing a content with 500 ppb of Cu or 500 ppb of Ni. Using the polishing composition containing Cu or Ni in this manner as a polishing slurry (working slurry), a surface of an object to be polished (sample piece) was polished under the following conditions, and then cleaned as the following conditions. As the sample piece, a commercially-available silicon single crystal wafer (conduction type: P type) that experienced lapping and etching and had a diameter of 150 mm was used.

### [Polishing Conditions]

Polishing machine: product name "SPM-15", manufactured by Fujikoshi Machinery Corp.
Polishing pad: product name "MH-S15A", manufactured by Nitta Haas Incorporated (present Nitta Dupont Incorporated)
Platen rotational speed: 38 rpm
Polishing pressure: 31.2 kPa
Polishing time: 20 mins
Supply flow rate of polishing slurry: 8 L/min (recycle use of a total of 40 L of a polishing slurry)
Retention temperature of polishing environment: 20°C

### [Cleaning Conditions]

The sample piece was removed from the polishing machine, immersed in a cleaning tank containing SC-1 cleaning liquid (31% hydrogen peroxide water : 29% ammonia water : water = 1:1:10 (volume ratio)) for 5 minutes, then immersed in a cleaning tank containing ultrapure water for 5 minutes, again immersed in a cleaning tank containing SC-1 cleaning liquid for 5 minutes, then immersed in a cleaning tank containing ultrapure water for 5 minutes, subsequently immersed in a cleaning tank containing SC-2 cleaning liquid (31% hydrogen peroxide water : 37% hydrogen chloride water : water = 1:1:6.6 (volume ratio)) for 5 minutes, then immersed in a cleaning tank containing ultrapure water for 5 minutes, and dried with a spin drier. Both liquid temperatures of SC-1 cleaning liquid and SC-2 cleaning liquid were 83°C.

The sample piece polished and cleaned in the aforementioned conditions was heat-treated at 200°C for 48 hours. Then, a natural oxide layer on the surface of the sample piece was subjected to vapor phase decomposition with hydrofluoric acid vapor, and recovered with a chemical containing hydrofluoric acid and hydrogen peroxide water.

Metallic impurities in the recovered chemical was subjected to quantitative analysis by inductively coupled plasm-mass spectrometry (ICP-MS4500) to derive a detectable amount [atm/cm²] of each metal analyte (Cu or Ni) per 1 cm² of surface area of the sample piece. On the basis of the value, metallic contamination prevention performance was evaluated according to the five levels described below. The results were shown in Table 2. In Comparative Example 10, quantitative analysis for the content of Cu in the recovered chemical exhibited overloading and failed to provide the detectable amount of Cu, and thus the corresponding column in Table 2 indicates "unmeasurable".
A: less than 1 × 10¹¹ atm/cm²
B: 1 × 10¹¹ atm/cm² or more, less than 5 × 10¹¹ atm/cm²
C: 5 × 10¹¹ atm/cm² or more, less than 50 × 10¹¹ atm/cm²
D: 50 × 10¹¹ atm/cm² or more, less than 500 × 10¹¹ atm/cm²
E: 500 × 10¹¹ atm/cm² or more

### [Table 2]

**Table 2**

| | Chelating agent | Visibility of dissolution of chelating agent | Metallic contamination prevention performance | |
|---|---|---|---|---|
| | | | Ni | Cu |
| Example 1 | EDTPO | V | A | A |
| Example 11 | DTPA | V | A | A |
| Example 12 | TTHA | V | A | A |
| Example 13 | EDDHA | V | A | B |
| Example 14 | EDTA | V | A | C |
| Example 15 | Asp | V | A | D |
| Example 16 | HEDP | V | A | D |
| Comparative Example 10 | None | - | D | unmeasurable |

As shown in Table 2, in Examples 11 to 16, visible observation of a chelating agent-containing liquid prepared in each of the examples successfully provided sufficient confirmation that a chelating agent dissolved well into the chelating agent-containing liquid in the same manner as in Example 1 (visibility: V). Furthermore, all the polishing composition produced by Examples 1 and 11 to 16 exerted metallic contamination prevention performance measurably higher than the chelating agent-free polishing composition produced by Comparative Example 10. In particular, the polishing compositions produced by Examples 1 and 11 to 13 exhibited high metallic contamination prevention performance, and the polishing compositions produced by Examples 1 and 11 to 12 exhibited particularly high metallic contamination prevention performance.

### <<Experimental Example 3>>

### <Production of Polishing Composition (concentrate)>

### (Example 17)

A basic chelating agent-containing liquid with 2.84% by weight of TMAH and 6.51 mM of EDTPO was prepared by adding EDTPO to an aqueous solution of TMAH and mixing together. Meanwhile, a silica dispersion having a pH of 13.0 and containing 1.1% by weight of TMAH and 42% by weight of silica particles (hereinafter referred to as "Silica dispersion D") was prepared by adding an aqueous solution of TMAH to a silica dispersion containing sodium silicate-derived silica (average secondary particle diameter: 71 nm) as silica particles.

To the chelating agent-containing liquid was added Silica dispersion D and K₂CO₃ in this order, thereby producing a polishing composition (concentrate) with a composition as follows: 30% by weight of silica particles, 1.5% by weight of TMAH, 1.2% by weight of K₂CO₃, and 1.74 mM of EDTPO.

### (Example 18)

A basic chelating agent-containing liquid with 1.96% by weight of TMAH and 2.4 mM of EDTPO was prepared by adding EDTPO to an aqueous solution of TMAH and mixing together.

To the chelating agent-containing liquid was added Silica dispersion D and K₂CO₃ in this order, thereby producing a polishing composition (concentrate) with a composition as follows: 25% by weight of silica particles, 1.5% by weight of TMAH, 1% by weight of K₂CO₃, and 1.05 mM of EDTPO.

### (Example 19)

A basic chelating agent-containing liquid with 14% by weight of TMAH and 92 mM of DTPA was prepared by adding DTPA to an aqueous solution of TMAH and mixing together.

To the chelating agent-containing liquid was added a silica dispersion having a pH of 7.5 and containing sol-gel-derived silica (average secondary particle diameter: 49 nm) as silica particles (Silica dispersion A), thereby producing a polishing composition (concentrate) with a final composition as follows: 18% by weight of silica particles, 1.8% by weight of TMAH, and 13 mM of DTPA.

### (Example 20)

A basic chelating agent-containing liquid with 12% by weight of KOH and 102 mM of DTPA was prepared by adding DTPA to an aqueous solution of KOH and mixing together.

To the chelating agent-containing liquid was added Silica dispersion A, thereby producing a polishing composition (concentrate) with a final composition as follows: 18% by weight of silica particles, 1.2% by weight of KOH, and 11 mM of DTPA.

Any of the chelating agent-containing liquids in Examples 1 to 20 described above had a pH of 13 or more.

### <Evaluation>

### (Visibility of Dissolution of Chelating Agent)

In production processes of polishing compositions (concentrates) according to Examples 17 to 20, whether a level of dissolution of a chelating agent can be checked visibly was evaluated in the same manner as in Experimental Example 1. The results are shown in Table 3.

### [Table 3]

**Table 3**

| | Mixing order | | | | Visibility of dissolution of chelating agent | Silica concentration of Concentrate (% by weight) |
|---|---|---|---|---|---|---|
| | 1 | 2 | 3 | 4 | | |
| Example 17 | TMAH | EDTPO | Silica dispersion D | K₂CO₃ | V | 30 |
| Example 18 | TMAH | EDTPO | Silica dispersion D | K₂CO₃ | V | 25 |
| Example 19 | TMAH | DTPA | Silica dispersion A | - | V | 18 |
| Example 20 | KOH | DTPA | Silica dispersion A | - | V | 18 |

As shown in Table 3, in Examples 17 to 20, visible observation of a chelating agent-containing liquid prepared in each of the examples successfully provided sufficient confirmation that a chelating agent dissolved well into the chelating agent-containing liquid in the same manner as in Example 1 (visibility: V).

The polishing compositions (concentrates) produced in Examples 17 to 20 can be diluted, e.g., about 20 to 50 folds with ultrapure water, thereby allowing the diluted polishing composition to be preferably used directly as a polishing slurry in polishing of a silicon material (e.g., stock polishing of a silicon wafer).

While specific examples of the present invention have been described above in detail, these are only illustrative, and do not limit the scope of the claims. The technologies recited in the claims include various modifications and alternations of the specific examples illustrated above.

## Claims

1. A production method of a polishing composition for polishing a surface formed of a silicon material, the method comprising:
preparing a basic chelating agent-containing liquid comprising a basic compound, water, and a chelating agent; and
mixing a silica dispersion comprising silica particles and water, and the chelating agent-containing liquid.

2. The production method according to claim 1, wherein the pH of the silica dispersion to be mixed with the chelating agent-containing liquid is 6 or more and 14 or less.

3. The production method according to claim 1 or 2,
wherein the chelating agent is an n-valent acid (n≥2), and
wherein pKaₙ₋₁ is more than 7.0 as the acid dissociation constant pKa of the chelating agent is defined as pKa₁ to pKaₙ in order of increasing numerical values.

4. The production method according to claim 1 or 2, comprising a pentavalent or more chelating agent as the chelating agent.

5. The production method according to claim 1 or 2, wherein the polishing composition is a polishing composition for stock polishing of the surface formed of the silicon material.

6. A polishing composition produced by the production method according to claim 1 or 2.
